(19) Europäisches Patentamt
European Patent Office
Office européen des brevets

(11) Veröffentlichungsnummer : **0 101 586**
**B1**

(12) # EUROPÄISCHE PATENTSCHRIFT

(45) Veröffentlichungstag der Patentschrift : **12.11.86**

(51) Int. Cl.⁴ : **G 03 F 7/10**, G 03 F 7/26

(21) Anmeldenummer : **83107689.8**

(22) Anmeldetag : **04.08.83**

(54) **Verfahren zur Herstellung von Tiefdruckformen mit Kunststoff-Druckschichten.**

(30) Priorität : **21.08.82 DE 3231144**

(43) Veröffentlichungstag der Anmeldung : **29.02.84 Patentblatt 84/09**

(45) Bekanntmachung des Hinweises auf die Patenterteilung : **12.11.86 Patentblatt 86/46**

(84) Benannte Vertragsstaaten : **BE CH DE FR GB IT LI NL**

(56) Entgegenhaltungen :
**EP-A- 0 019 770**
**DE-A- 2 150 691**
**DE-A- 2 242 394**
**DE-A- 2 309 062**

(73) Patentinhaber : **BASF Aktiengesellschaft**
**Carl-Bosch-Strasse 38**
**D-6700 Ludwigshafen (DE)**

(72) Erfinder : **Lynch, John, Dr.**
**Bachusstrasse 15**
**D-6521 Monsheim (DE)**
Erfinder : **Leyrer, Reinhold J., Dr.**
**Menzelstrasse 4**
**D-6700 Ludwigshafen (DE)**
Erfinder : **Saenger, Dietrich, Dr.**
**Lorcher Ring 16 a**
**D-6710 Frankenthal (DE)**

**EP 0 101 586 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein Verfahren zur Herstellung von Tiefdruckformen mit einer auf einem Druckformträger aufgebrachten Kunststoff-Druckschicht durch bildmäßiges Belichten mit aktinischem Licht einer auf dem Druckformträger aufgebrachten festen, lichtempfindlichen Schicht (S), Auswaschen der belichteten Schicht (S) mit einem Entwicklerlösungsmittel und thermisches Härten dieser Schicht (S) zur Ausbildung einer harten, abrieb- und kratzfesten Kunststoff-Druckschicht.

Während heute im Hochdruck aufgrund ihrer leichteren Herstellung im großen Umfang Fotopolymer-Reliefdruckformen Eingang gefunden haben, arbeitet man beim Tiefdruck immer noch mit Metalldruckformen, die im allgemeinen an der Oberfläche als eigentliche Druckschicht eine verchromte Kupferschicht aufweisen, in der sich die für die Farbaufnahme erforderlichen Vertiefungen (Näpfchen) befinden. Die hohen Kosten der Herstellung solcher Metalltiefdruckformen hat den Tiefdruck auf Anwendungsgebiete beschränkt, in denen neben hoher Druckqualität eine große Auflagenhöhe gefordert ist.

Aus der DE-A-2 752 500 ist bekannt, Tiefdruckformen aus Kunststoff herzustellen, wobei die Näpfchen mechanisch eingraviert werden. Zur Vermeidung von Schrammen und Riefen an der Oberfläche dieser Tiefdruckformen werden hierbei anstelle üblicher Stahlrakeln spezielle Kunststoffrakeln beim Druck verwandt. Doch werder die umständliche Herstellung solcher Tiefdruckformen noch die damit erzielbaren Auflagenhöhen beim Druck sind befriedigend.

Die Herstellung von Tiefdruckformen durch bildmäßiges Belichten von fotopolymerisierbaren Gemischen, wie sie für die Herstellung von Hochdruckformen verwendet werden, ist z. B. in der DE-A-2 054 833, der DE-A 2 061 287 sowie der japanischen Patentanmeldung 41361/72 beschrieben. Solche Tiefdruckformen sind jedoch bezüglich der Kratzfestigkeit ihrer Oberflächen und in der damit erzielbaren Auflagenhöhen noch nicht befriedigend.

In der EP-A1-70511 werden zur Herstellung von Tiefdruckformen mit abrieb- und kratzfesten Kunststoff-Druckschichten fotopolymerisierbare Aufzeichnungsmaterialien beschrieben, die in der fotopolymerisierbaren Schicht harte, abrasive, feinteilige Partikel enthalten. In der EP-A1-70510 wird vorgeschlagen, zur Erzielung einer harten, nicht spröden Fotopolymer-Tiefdruckform die Fotopolymerschicht, der in üblicher Weise hergestellten Fotopolymer-Tiefdruckform durch Einbrennen bei 200 bis 260 °C um 10 bis 50 % der Schichtdicke der Fotopolymerschicht zu schrumpfen. Gemäß diesen beiden älteren Anmeldungen geht man zur Herstellung von abrieb- und kratzfesten Tiefdruckformen mit Kunststoff-Druckschichten von fotopolymerisierbaren Materialien aus, die ein polymeres Bindemittel, mindestens eine damit verträgliche fotopolymerisierbare olefinisch ungesättigte Verbindung sowie einen Fotoinitiator enthalten.

Aufgabe der vorliegenden Erfindung ist es, ein weiteres einfaches Verfahren zur Herstellung von Tiefdruckformen mit Kunststoff-Druckschichten aufzuzeigen, welches variabel und allgemein anwendbar ist und zu Druckformen mit hoher Abrieb- und Kratzfestigkeit bei gleichzeitig sehr guten sonstigen Druckeigenschaften führt.

Es wurde überraschend gefunden, daß diese Aufgabe gelöst wird, wenn man von einer auf einem Druckformträger aufgebrachten lichtempfindlichen Schicht ausgeht, die eine Verbindung mit mindestens zwei aromatischen und/oder heteroaromatischen o-Nitrocarbinolestergruppierungen und eine vernetzend wirkende Verbindung mit mindestens zwei reaktiven Gruppen enthält, die mit —COOH-Gruppen unter Bildung einer kovalenten chemischen Bindung zu reagieren vermögen, und diese lichtempfindliche Schicht bildmäßig mit aktinischem Licht belichtet und anschließend entweder mit einem wäßrigen Entwicklerlösungsmittel auswäscht, danach vollflächig mit aktinischem Licht nachbelichtet und termisch vernetzt und härtet oder in den belichteten Bereichen selektiv thermisch härtet und vernetzt und danach mit einem Entwicklerlösungsmittel auswäscht.

Gegenstand der Erfindung ist dementsprechend ein Verfahren zur Herstellung von Tiefdruckformen mit einer auf einem Druckformträger aufgebrachten Kunststoff-Druckschicht durch bildmäßiges Belichten mit aktinischem Licht einer auf den Druckformträger haftfest aufgebrachten festen lichtempfindlichen Schicht (S), Auswaschen der belichteten Schicht (S) mit einem Entwicklerlösungsmittel und thermisches Härten dieser Schicht (S) zur Ausbildung der harten und abriebfesten Kuntstoff-Druckschicht, welches dadurch gekennzeichnet ist, daß die lichtempfindliche Schicht (S) als lichtempfindliche Komponente eine Verbindung mit mindestens zwei aromatischen und/oder heteroaromatischen o-Nitrocarbinolestergruppierungen der allgemeinen Formel (I)

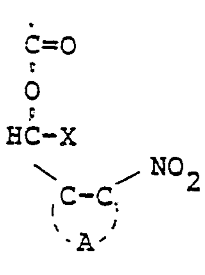

(I)

enthält, worin

A den Rest eines aromatischen oder heteroaromatischen, gegebenenfalls substituierten Ringsystems mit 5 bis 14 Ringgliedern und

X ein Wasserstoffatom, einen Alkylrest mit 1 bis 8 Kohlenstoffatomen oder einen gegebenenfalls substituierten Aryl- oder Aralkylrest bedeuten, und daß die lichtempfindliche Schicht (S) eine vernetzend wirkende Verbindung mit mindestens zwei reaktiven Gruppen enthält, die unter dem Einfluß von Wärme mit —COOH-Gruppen unter Bildung einer kovalenten chemischen Bindung zu reagieren vermögen, und daß die lichtempfindliche Schicht (S) nach dem bildmäßigen Belichten entweder mit einem wäßrigen Entwicklerlösungsmittel ausgewaschen, anschließend vollflächig mit aktinischem Licht nachbelichtet und darauf thermisch vernetzt und gehärtet wird, oder in den belichteten Bereichen selektiv thermisch gehärtet und vernetzt und danach mit einem Entwicklerlösungsmittel ausgewaschen wird.

Aus der DE-A-2 150 691 sowie DE-A-2 922 746 sind lichtempfindliche Aufzeichnungsmaterialien zur Verwendung als Fotoresist oder Herstellung von Flachdruckplatten bekannt, die als lichtempfindliche Komponente ein Polymeres mit aromatischen und/oder heteroaromatischen o-Nitrocarbinolestergruppierungen enthalten. In der DE-B-2 309 062 sowie der DE-A-2 242 394 werden lichtempfindliche, härtbare Materialien aus einer Verbindung mit mindestens zwei o-Nitrocarbinolestergruppierungen und Epoxiden, Isocyanaten oder Aziridinen zur Herstellung von Fotoresist-Schichten oder Offsetdruckplatten bzw. von Formkörpern, Imprägnierungen, Beschichtungen, Überzügen und Druckfarben beschrieben. Es hat sich nun überraschenderweise gezeigt, daß lichtempfindliche Schichten, die eine Verbindung mit mindestens zwei o-Nitrocarbinolestergruppierungen und eine vernetzend wirkende Verbindung mit mindestens zwei gegenüber Carboxylgruppen reaktiven Gruppen enthalten, nach dem erfindungsgemäßen Verfahren zu Tiefdruckformen hoher Qualität verarbeitet werden können. Die erfindungsgemäß hergestellten Tiefdruckformen haben nicht nur eine hohe Abrieb- und Kratzfestigkeit, die dem Niveau der konventionellen Metalltiefdruckformen entspricht, sondern zeigen auch derart gute Druckeigenschaften, daß sie ohne Nachteile und Qualitätseinbußen für den Qualitätstiefdruck eingesetzt werden können. Man kann die erfindungsgemäß hergestellten Tiefdruckformen in den üblichen, gebräuchlichen Tiefdruck-Maschinen einsetzen und hierbei sehr hohe Auflagenhöhen erreichen. Das erfindungsgemäße Verfahren ist je nach Wahl und Reihenfolge der Verfahrensschritte äußerst variabel und erlaubt dadurch eine leichte Anpassung an die von der Anwendungsseite her gestellten jeweiligen Erfordernisse. Ein weiterer großer Vorteil des erfindungsgemäßen Verfahrens liegt darin, daß das Auswaschen der belichteten Druckschicht mit wäßrigen Entwicklerlösungsmitteln vorgenommen werden kann, ohne daß es hierdurch zu nachteiligen Einflüssen auf wichtige Eigenschaften der Kunststoff-Druckschicht, wie z. B. Festigkeit, Resistenz und Härte, kommt.

Unter Tiefdruckformen werden im Rahmen dieser Erfindung Druckplatten, Druckfolien oder Druckzylinder mit Reliefformen verstanden, die die farbführenden Bildteile für den Druck als Vertiefungen (Näpfchen) in der Oberfläche enthalten. Bei den nach dem erfindungsgemäßen Verfahren hergestellten Tiefdruckformen befinden sich diese farbaufnehmenden Vertiefungen in der Schicht (S), die im allgemeinen haftfest auf dem dimensionstabilen Druckformträger, beispielsweise einer Metallplatte oder einem Metallzylinder, aufgebracht ist. Die Stärke der Kunststoff-Druckschicht und somit auch die Stärke der lichtempfindlichen Schicht (S) liegt im allgemeinen im Bereich von 5 bis 500 µm, vorzugsweise im Bereich von 20 bis 250 µm. Die Tiefe der Näpfchen, die die Druckfarbe aufnehmen, beträgt im allgemeinen wenige µm, z. B. 2 bis 3 µm für Näpfchen kleiner Tiefe und 10 bis 100 µm, insbesondere 20 bis 60 µm für Näpfchen großer Tiefe.

Zur Durchführung der erfindungsgemäßen Verfahrens wird auf den eigentlichen Druckformträger, im allgemeinen eine Metallplatte oder ein Metallzylinder, die lichtempfindliche Schicht (S) nach den bekannten Auftragstechniken entweder aus Lösung, z. B. durch spin-coating, Rasterwalzenauftrag, Tauchbeschichtung, Vorhanggießen, Lippengießen etc., oder trocknen nach den gebräuchlichen Laminierverfahren aufgebracht. Tiefdruckzylinder können endlos mit einer Ringbeschichtungsmaschine beschichtet werden. Zur Erzielung einer guten Haftung zwischen der lichtempfindlichen Schicht (S) und dem Druckformträger ist es oft zweckmäßig, den Druckformträger vor dem Aufbringen der Schicht (S) mit einer dünnen Schicht eines Haftvermittlers, beispielsweise auf Basis von Polyurethan-Reaktionslacken, Phenolharzen und/oder Epoxidharzen, zu versehen.

Die lichtempfindliche Schicht (S) enthält erfindungsgemäß als lichtempfindliche Komponente eine Verbindung mit mindestens zwei aromatischen und/oder heteroaromatischen o-Nitrocarbinolestergruppierungen der allgemeinen Formel (I)

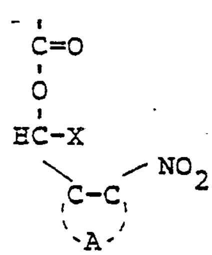

(I)

worin

A den Rest eines aromatischen oder heteroaromatischen, gegebenenfalls substituierten Ringsystems mit 5 bis 14 Ringgliedern und

X ein Wasserstoffatom, einen Alkylrest mit 1 bis 8 Kohlenstoffatomen oder einen gegebenenfalls substituierten Aryl- oder Aralkylrest bedeuten.

Das aromatische oder heteroaromatische Ringsystem A mit der ortho-ständigen Nitrogruppe kann ein- oder mehrkernig sein. Unter den aromatischen Ringsystemen ist insbesondere das Benzol bevorzugt, wobei der Benzolring ein- oder mehrfach substituiert sein kann, beispielsweise durch $C_1$-$C_8$-Alkyl, insbesondere Methyl, durch $C_1$-$C_6$-Alkoxy, insbesondere Methoxy, durch Halogen, wie Chlor oder Brom, durch Nitro-, Amino-, Monomethylamino-, Dimethylamino-, Nitril- oder Sulfo-Gruppen. Als mehrkernige aromatische Ringsysteme kommen z. B. Naphthalin, Anthrazen, Anthrachinon, Phenanthren oder die entsprechenden substituierten Derivate in Betracht. Als heteroaromatisches Ringsystem ist der Pyridinrest bevorzugt. X ist insbesondere ein Wasserstoffatom, der Methyl- oder Ethylrest oder der gegebenenfalls substituiert Phenylrest.

Beispiele für besonders bevorzugte aromatische oder heteroaromatische o-Nitrocarbinole, die den o-Nitrocarbinolestergruppierungen der allgemeinen Formel (I) zugrundeliegen, sind o-Nitrobenzylalkohol, 2-Nitro-6-chlorbenzylalkohol, 2-Nitro-4-cyanobenzylalkohol, 2-Nitro-4,5-dimethoxybenzylalkohol, α-Methyl-o-nitrobenzylalkohol, α-Phenyl-o-nitrobenzylalkohol, α-(o-Nitrophenyl)-o-nitrobenzylalkohol und 2-Nitro-3-hydroxymethylpyridin.

Als Verbindung mit den aromatischen und/oder heteroaromatischen o-Nitrocarbinolestergruppierungen kommen niedermolekulare Ester mit zwei oder mehr Estergruppierungen der allgemeinen Formel (I) in Betracht. Hierzu gehören insbesondere die Di- und/oder Polyester von niedermolekularen Di- und/oder Polycarbonsäuren mit aromatischen und/oder heteroaromatischen o-Nitrocarbinolen der in Rede stehenden Art. Beispiele für niedermolekulare Di- und Polycarbonsäuren, die solchen Estern zugrundeliegen können, sind Oxalsäure, Malonsäure, Adipinsäure, Maleinsäure, Fumarsäure, Crotonsäure, Terephthalsäure, Trimellithsäure und Trimesinsäure.

Werden als lichtempfindliche Komponente niedermolekulare o-Nitrocarbinolestergruppierungen der Formel (I) enthaltende Verbindungen eingesetzt, so enthält die lichtempfindliche Schicht (S) vorteilhaft noch ein mit diesen Estern verträgliches polymers Bindemittel, wobei sich hierfür z. B. Acrylat- und/oder Methacrylat-Polymerisate besonders bewährt haben. Als polymere Bindemittel für die lichtempfindliche Schicht (S) kommen auch insbesondere die nachfolgend beschriebenen hochmolekularen vernetzend wirkenden Verbindungen mit gegenüber Carboxylgruppen reaktiven Gruppen in Betracht. Im Fall des Einsatzes von niedermolekularen, o-Nitrocarbinolestergruppierungen der Formel (I) enthaltenden Verbindungen als lichtempfindlicher Komponente wird deren Menge in der lichtempfindlichen Schicht (S) so bemessen, daß durch die Belichtung mit aktinischem Licht eine hinreichende Anzahl von freien Carboxylgruppen gebildet werden können, die bei der thermischen Härtung und Vernetzung der Schicht (S) ausreichen, um den gewünschten und angestrebten Vernetzungs- und Härtungsgrad zu erzielen. Hierzu ist es im allgemeinen hinreichend, wenn in der lichtempfindlichen Schicht (S) 2 bis 30 Gew.-%, insbesondere 10 bis 15 Gew.-%, der aromatischen und/oder heteroaromatischen o-Nitrocarbinolestergruppierungen der Formel (I), berechnet als —COO—, bezogen auf die gesamte lichtempfindliche Schicht (S), enthalten sind.

Besonders bewährt haben sich in dem erfindungsgemäßen Verfahren zur Herstellung von Tiefdruckformen lichtempfindliche Schichten (S), die als lichtempfindliche Komponente ein Polymeres mit einem Molekulargewicht > 500 enthalten, welches mindestens 5 Gew.-%, bezogen auf das Molekulargewicht des Polymeren, aromatische und/oder heteroaromatische o-Nitrocarbinolestergruppierungen der allgemeinen Formel (I) im Molekül gebunden enthält. Bezüglich dieser Polymeren mit den o-Nitrocarbinolestergruppierungen der Formel (I) sowie deren Herstellung sei insbesondere auf die Angaben in der DE-A-2 150 691 verwiesen.

Als das die o-Nitrocarbinolestergruppierungen tragende Polymer kommt zweckmäßigerweise eine organische Polycarbonsäure in Betracht, deren Carboxylgruppen mit den aromatischen und/oder heteroaromatischen o-Nitrocarbinolen der in Rede stehenden Art verestert sind. Bei den organischen Polycarbonsäuren handelt es sich im allgemeinen um Homopolymere oder Copolymere von ethylenisch ungesättigten Mono- oder Dicarbonsäuren mit 2 bis 6 Kohlenstoffatomen, insbesondere um Homo- oder Copolymerisate von Acrylsäure, Methacrylsäure, Maleinsäure, Fumarsäure oder Crotonsäure. Als Comonomeren kommt dabei Ethylen, Styrol und den $C_1$-$C_8$-Alkylestern der oben genannten ethylenisch ungesättigten Carbonsäuren besondere Bedeutung zu.

Es sei darauf hingewiesen, daß praktisch alle Carboxylgruppen der o-Nitrocarbinolestergruppierungen tragenden Polycarbonsäure verestert sein oder zumindest in einer Form vorliegen müssen, die mit den reaktiven Gruppen der nachfolgend beschriebenen vernetzend wirkenden Komponente nicht direkt reagieren kann, falls eine gute Lagerstabilität des lichtempfindlichen Materials als solchen oder der auf den Druckormträger aufgebrachten lichtempfindlichen Schicht (S) im Dunkeln oder im Gelblicht gewünscht wird. Anderenfalls besteht nämlich die Gefahr, daß das lichtempfindliche Material bereits vor der Belichtung mit aktinischem Licht, z. B. während der Lagerung, teilweise vernetzt und härtet, wodurch es für den Einsatz in dem erfindungsgemäßen Verfahren nur mit Einschränkungen geeignet sein würde.

Die Menge an o-Nitrocarbinolestergruppierungen der Formel (I) die in dem Polymeren eingebaut

sind, wird im allgemeinen nicht unter 5 Gew.-%, bezogen auf das Molekulargewicht des Polymeren, liegen und kann in Abhängigkeit von den gewünschten Eigenschaften der lichtempfindlichen Schicht (S) bzw. der hieraus hergestellten Druckschicht in weiten Grenzen schwanken. Da bei der Belichtung mit aktinischem Licht die o-Nitrocarbinolestergruppierungen gespalten und freie Carboxylgruppen im Polymeren gebildet werden, wodurch die Löslichkeit des Polymeren geändert wird, wird beispielsweise der Gehalt an o-Nitrocarbinolestergruppierungen der allgemeinen Formel (I) in den Polymeren so gewählt, daß die Polymeren nach der Belichtung der lichtempfindlichen Schicht (S) in wäßrigen Lösungsmitteln, wie z. B. Wasser oder wäßrig-alkalischen Lösungen, löslich oder zumindest dispergierbar sind und mit diesen ausgewaschen werden können. Ebenso ist der Gehalt an o-Nitrocarbinolestergruppierungen der allgemeinen Formel (I) in den Polymeren auf den gewünschten Vernetzungsgrad bei der thermischen Härtung der Schicht (S) abzustimmen.

Die in dem erfindungsgemäßen Verfahren einzusetzende lichtempfindliche Schicht (S) enthält auch eine oder mehrere vernetzend wirkende Verbindungen mit mindestens zwei reaktiven Gruppen, die unter dem Einfluß von Wärme mit —COOH-Gruppen unter Bildung einer kovalenten chemischen Bindung zu reagieren vermögen. Da gemäß den verschiedenen Ausgestaltungsformen des erfindungsgemäßen Verfahrens das Auswaschen der lichtempfindlichen Schicht (S) nach einer Belichtung mit aktinischem Licht erfolgt, ist die Reaktivität dieser vernetzend wirkenden reaktiven Gruppen so auf die übrigen Verfahrensbedingungen, insbesondere Dauer und Temperatur für die Entwicklung, abzustimmen, daß nach der Belichtung mit aktinischem Licht noch ein einwandfreies Auswaschen der Schicht (S) mit den Entwicklerlösungsmittln gewährleistet bleibt. Es sind daher vorzugsweise solche vernetzend wirkenden Verbindungen in der lichtempfindlichen Schicht (S) enthalten, die erst in der Wärme bei erhöhter Temperatur, beispielsweise bei Temperaturen oberhalb 40 °C, in merklicher Geschwindigkeit mit den freien Carboxylgruppen reagieren. Reaktive, vernetzend wirkende Gruppen der in Rede stehenden Art, die für das erfindungsgemäße Verfahren besonders geeignet sind, sind beispielsweise Amin-, Imin-, Amid-, Epoxid-, Hydroxy- und/oder gegebenenfalls verkappte Isocyanat-Gruppen.

Gemäß einer Ausführungsform der erfindungsgemäßen Verfahrens können solche lichtempfindlichen Schichten (S) verwendet werden, in denen die aromatischen und/oder heteroaromatischen o-Nitrocarbinolestergruppierungen der allgemeinen Formel (I) sowie die vernetzend wirkenden reaktiven Gruppen der obengenannten Art in ein und demselben Molekül gebunden enthalten sind. Hierbei handelt es sich insbesondere um aromatische und/oder heteroaromatische o-Nitrocarbinolestergruppierungen tragende Copolymerisate, die Comonomere mit den vernetzend wirkenden, reaktiven Gruppen, z. B. Amin-, Imin-, Amid-, Epoxid-, Hydroxy- und/oder gegebenenfalls verkappten Isocyanat-Gruppen, einpolymerisiert enthalten. Als Comonomere mit den vernetzend wirkenden, gegenüber Carboxylgruppen reaktiven Gruppen, die in den die aromatischen und/oder heteroaromatischen o-Nitrocarbinolestergruppierungen der Formel (I) tragenden Polymeren einpolymerisiert sein können, kommen insbesondere solche mit Epoxid-, Hydroxy-, Isocyanat- und/oder verkappten Isocyanat-Gruppen in Betracht. Beispielhaft seien genannt : N,N-Dimethylaminoethyl-(meth)acrylat ; N-Vinylimidazol ; (Meth)acrylamid sowie vorzugsweise Glycidylester ungesättigter Säuren, insbesondere der Acryl- oder Methacrylsäure, wie Glycidyl-(meth)-acrylat ; Glycidylether ungesättigter Alkohole, wie z. B. Allylglycidylether oder 4-Vinylcyclohexendioxid ; Vinylisocyanat, Allylisocyanat ; Monoester von Diolen mit ungesättigten Säuren, insbesondere von Acryl- oder Methacrylsäure, wie z. B. Hydroxyethyl-(meth)acrylat, Hydroxypropyl-(meth)acrylat oder Butandiol-mono(meth)acrylat ; und Methylolverbindungen vom Amoltyp, z. B. N-Methylolacrylamid.

Gemäß einer anderen Ausführungsform der Erfindung können die vernetzend wirkenden Verbindungen mit den reaktiven Gruppen zusätzlich zu den Verbindungen mit den aromatischen und/oder heteroaromatischen o-Nitrocarbinolestergruppierungen in der lichtempfindlichen Schicht (S) enthalten sein.

In diesem Fall kann es sich bei den vernetzend wirkenden Verbindungen sowohl um höhermolekulare Verbindungen, wie z. B. entsprechende Polymere, oder um entsprechende niedermolekulare Verbindungen handeln. Wenn die vernetzend wirkenden Verbindungen mit den reaktiven Gruppen als Zumischkomponente in die lichtempfindliche Schicht (S) eingebracht werden, sollen sie mit den die aromatischen und/oder heteroaromatischen o-Nitrocarbinolestergruppierungen enthaltenden Verbindungen verträglich sein. Bevorzugte Klassen von vernetzend wirkenden Verbindungen mit zwei oder mehr der reaktiven Gruppen, die als Zumischkomponente in der lichtempfindlichen Schicht (S) enthalten sein können, sind Di- oder Polyepoxide, freie oder verkappte Di- oder Polyisocyanate, Carbodiimide, Di- oder Polyhydroxide sowie Di- oder Polyamine. Die lichtempfindliche Schicht (S) kann dabei nur eine oder auch mehrere der vernetzend wirkenden Verbindungen enthalten. Beispielsweise ist es möglich, daß die lichtempfindliche Schicht (S) zwei oder mehr verschiedenartige vernetzend wirkende Verbindungen, wie Epoxide, Isocyanate und/oder verkappte Isocyanate, enthält.

Die Di- oder Polyepoxide umfassen die Umsetzungsprodukte von Epichlorhydrin mit Polyolen, die Umsetzungsprodukte von Epichlorhydrin mit Polyaminen, Polyolefinepoxide, epoxidiertes Polybutadien, Epoxyharze vom Novolaktyp, Hochpolymere von Glycidylestern ungesättigter Carbonsäuren insbesondere der (Meth)acrylsäure, und andere. Von besonderem Interesse sind die Epoxide auf Basis von Epichlorhydrin und Bisphenol A. Eine andere Gruppen von geeigneten Epoxiden sind diejenigen, in denen die endständigen Glycidylgruppen durch aliphatische oder araliphatische Reste verbunden sind. Ein typischer Vertreter dieser Klasse ist der Diglycidylether des 1,4-Butandiols. Derartige Epoxide führen

beispielsweise wegen des weniger starren Molekülaufbaus zu flexibleren Härtungsprodukten. Werden Amine anstelle der mehrwertigen Alkohole mit Epichlorhydrin zur Herstellung der Epoxidverbindungen herangezogen, so erhält man Epoxipropylamine, die im Aufbauprinzip den Glycidylethern ähnlich sind. Ein typischer Vertreter hierfür ist das Bis(epoxipropyl)anilin, welches aufgrund seiner äußerst niedrigen Viskosität als bifunktioneller Verdünner eingesetzt werden kann. Als hochmolekulare vernetzend wirkende Verbindungen sind u. a. die Epoxidharze vom Novolaktyp von Interesse. Aufgrund ihrer hohen Funktionalität ergeben sie mit den fotochemisch erzeugten Carbonsäure-Gruppen hochvernetzte Systeme mit hoher Wärmeformbeständigkeit. Das gleiche gilt, wenn Polyglycidyl(meth)acrylate oder andere Glycidylgruppen enthaltende Polymere verwendet werden.

Durch den Einsatz von cycloaliphatischen Epoxiden, die in ihrem Molekül ein oder mehrere cycloaliphatische Ringe, jedoch keine aromatischen Ringe enthalten, kann z. B. die Lagerstabilität und UV-Beständigkeit erhöht werden. Bei den cycloaliphatischen Epoxiden kann der Epoxidsauerstoff ausschließlich an die cycloaliphatischen Ringe gebunden sein, wie z. B. im Dicyclopentadiendioxid, er kann ausschließlich in den Seitenketten gebunden sein, wie z. B. beim Diglycidylester der Hexahydrophthalsäure, oder er kann sowohl an den cyclischen Ringen als auch an die Seitenketten gebunden sein, wie z. B. beim Vinylcyclohexendioxid.

Weiterhin kommen als vernetzend wirkende Verbindungen die üblichen Polyisocyanate mit zwei oder mehr Isocyanatgruppen pro Molekül in Betracht, z. B. Alkyl- und Cycloalkyldiisocyanate mit vorzugsweise 4 bis 41 Kohlenstoffatomen im Alkyl- bzw. Cycloalkylrest, wie z. B. Dimersäurediisocyanat, Isophorondiisocyanat, Dicyclohexylmethandiisocyanat, 1,4-Butandiisocyanat, Hexamethylendiisocyanat, Heptadecandiisocyanat, 2,2,4-Trimethylhexamethylendiisocyanat, 2,6-Diisocyanatomethylcaproat, Isocyanuratisocyanate, z. B. das Produkt aus der Umsetzung von 2,4-Toluylendiisocyanat mit Hexamethylendiisocyanat, Biurete, wie Hexamethylendiisocyanatbiuret, Aryldi- und- triisocyanate, wie z. B. Toluylendiisocyanat, Diphenylmethandiisocyanat, Naphthylendiisocyanat, Triphenylmethantriisocyanat, Xylylendiisocyanat, gemischte aliphatisch-aromatische Di- und Triisocyanate, funktionelle Gruppierungen enthaltende Di- und Triisocyanate, wie z. B. Carbonylisocyanate, wie Carbonyldiisocyanat oder Isophthaloyldiisocyanat, Sulfarylisocyanate, Sulfonyldiisocyanat oder m-Phenylendisulfonyldiisocyanat, Allophanatisocyanate, Heteroatome enthaltende Di- und Triisocyanate, wie z. B. Umsetzungsprodukte aus Hexamethylcyclotrisilazan und Diphenylmethandiisocyanat, sowie Isocyanatgruppen enthaltende Polymere, z. B. Mischpolymerisate des Vinylisocyanats, Hydroxylgruppen und/oder Aminogruppen enthaltende Polymerisate oder Polykondensate, die mit einem Überschuß an Di- oder Triisocyanaten umgesetzt worden sind.

Da die lichtempfindliche Schicht (S) in dem erfindungsgemäßen Verfahren erst durch die Einwirkung von aktinischem Licht in den Zustand der thermischen Härtbarkeit gebracht wird, braucht die Isocyanatkomponente nicht verkappt zu sein, um eine hohe Lagerstabilität des lichtempfindlichen Materials vor der Verarbeitung in dem erfindungsgemäßen Verfahren zu erreichen. Sofern in dem erfindungsgemäßen Verfahren jedoch ein großer Verarbeitungsspielraum bei dem Entwickeln der belichteten Schicht (S) gewünscht wird, werden vorteilhaft verkappte Isocyanate als vernetzend wirkende Komponenten in der lichtempfindlichen Schicht (S) verwendet. Da sich die verkappten Isocyanate erst bei erhöhter Temperatur wieder in die Ausgangskomponenten spalten, ist bei Einsatz von verkappten Isocyanaten als vernetzend wirkenden Verbindungen die Schicht (S) nach der Belichtung mit aktinischem Licht bei Raumtemperatur völlig indifferent und besitzt somit einen sehr hohen Verarbeitungsspielraum.

Als schützende Komponente für die Verkappung der Isocyanate kommen hauptsächlich Phenole, Acetonoxim, Methylethylketoxim, Acetessigester oder Malonester infrage; es eignen sich jedoch ebenfalls Verbindungen wie Acetylaceton, Phthalimid, Caprolactam, Benzolsulfonamid und 2-Mercaptobenzthiazol. Eine gut geeignete, hochwirksame verkappte Isocyanatverbindung erhält man beispielsweise aus einem Mol Trimethylolpropan, 3 Mol 2,4-Diisocyanatotoluol und 3 Mol Phenol. Als weiteres Beispiel für ein verkapptes Isocyanat sei das Isocyanuratderivat genannt, welches durch Trimerisierung des Umsetzungsproduktes von 2,4-Diisocyanatotoluol und Kresol erhalten wird. Ebenfalls hervorragend als vernetzend wirkende Verbindung geeignet sind die aus Toluylendiisocyanat, Trimethylolpropan, Butandiol und Kresol hergestellten verkappten Isocyanate.

Eine weitere Gruppe von sehr geeigneten vernetzend wirkenden Verbindungen sind wegen ihrer leichten Reaktion mit Carbonsäure-Gruppen die bekannten und üblichen Carbodiimide, wie sie durch Carbodiimidisierung von Diisocyanaten entstehen. Werden als vernetzend wirkende Verbindung $\alpha,\omega$-Diisocyanato-polycarbodiimide eingesetzt, erhält man bei der erfindungsgemäßen Härtung der Schicht (S) ein dichtes Netzwerk unter Ausbildung von Polyacylharnstoff. Die Carbodiimide können sowohl aus aromatischen, als auch aus aliphatischen Diisocyanaten aufgebaut sein. $\alpha,\omega$-Diisocyanato-polycarbodiimide aus Isophorondiisocyanat sind in dem erfindungsgemäßen Verfahren als vernetzend wirkende Verbindung u. a. deswegen besonders gut geeignet, da sie als verkapptes Polyisocyanat einen hohen Verarbeitungsspielraum bei dem Entwickeln der Schicht (S) gewährleisten.

Vorteilhafte vernetzend wirkende Verbindungen mit mindestens zwei reaktiven Gruppen sind ferner Polymere, die Hydroxy- oder Amino-Gruppen eingebaut enthalten. Erwähnt seien z. B. Phenol-Formaldehydharze, Harnstoff-Formaldehydharze und Melamin-Formaldehydharze. Besonders geeignete Verbindungen aus dieser Klasse sind die Novolake. Zu diesen polymeren vernetzend wirkenden Verbindungen gehören auch beispielsweise die Polyglycidyl(meth)acrylate.

Die hochmolekularen vernetzend wirkenden Verbindungen mit den reaktiven Gruppen werden in der

lichtemfindlichen Schicht (S) bevorzugt dann eingesetzt, wenn die Verbindungen mit den o-Nitrocarbinolestergruppierungen ein relativ niedriges Molekulargewicht besitzen. Wenn die Verbindung mit den o-Nitrocarbinolestergruppierungen ein Polymeres mit hohem Molekulargewicht ist, können die zugesetzten vernetzend wirkenden Verbindungen mit den reaktiven Gruppen niedermolekular oder auch hochmolekular sein.

Das Verhältnis der reaktiven Gruppen in den vernetzend wirkenden Verbindungen zu den o-Nitrocarbinolestergruppierungen der allgemeinen Formel (I) in den diese Gruppierungen enthaltenden Verbindungen kann in weiten Grenzen variiert werden, so daß der gewünschte Vernetzungs- und Härtungsgrad der Schicht (S) und damit die gewünschten mechanischen Eigenschaften und Lösungsmittelbeständigkeit erreicht wird.

Die in dem erfindungsgemäßen Verfahren eingesetzten lichtempfindlichen Schichten (S) können darüber hinaus weitere übliche und an sich bekannte Zusatz- und Hilfsstoffe enthalten. Hierbei kann es sich einerseits um Verbindungen handeln, die die Herstellung der lichtempfindlichen Schicht (S) erleichtern, wie z. B. Weichmacher oder Verlaufsmittel. Beispiele für weichmachende Verbindungen, die insbesondere dann zugesetzt werden, wenn die lichtempfindliche Schicht (S) durch Laminieren auf den Druckformträger aufgebracht werden soll und die mit den die o-Nitrocarbinolestergruppierungen enthaltenden Verbindungen verträglich sein sollen, sind Trikresylphosphat, n-Butyl-benzyl-phthalat und flüssige Polyester aus aliphatischen Dicarbonsäuren und bifunktionellen Glykolen, insbesondere Polyester aus Adipinsäure und 1,2-Propylen-glykol oder 1,4-Butandiol mit einer Viskosität von 1 000 bis 15 000 mPa · s. Werden als vernetzend wirkende Verbindungen mit mindestens zwei reaktiven Gruppen niedermolekulare Substanzen als Zumischkomponente eingesetzt, so können diese auch als Weichmacher wirken und den Zusatz von gesonderten weichmachenden Verbindungen teilweise oder vollständig überflüssig machen. Verlaufsmittel, wie z. B. Silikonöle, sind insbesondere dann empfehlenswert, wenn die lichtempfindliche Schicht durch Gießen aus Lösung auf einen Träger aufgebracht werden soll.

Andererseits können die lichtempfindlichen Schichten (S) solche Zusatzstoffe enthalten, die die anwendungstechnischen Eigenschaften der Schicht verbessern oder modifizieren. Hierzu gehören beispielsweise Katalysatoren, die die thermische Härtung der belichteten Schicht (S), d. h. also die Umsetzung zwischen den freien Carboxylgruppen und den reaktiven Gruppen der vernetzend wirkenden Verbindungen, beschleunigen ; Sensibilisatoren, die die Lichtempfindlichkeit und die spektrale Empfindlichkeit der Schicht (S) verbessern ; Farbstoffe, Pigmente und/oder photochrome Substanzen sowie feinteilige Füllstoffe.

Als Katalysatoren für die thermische Härtung der Schicht (S) können je nach Art der verwendeten vernetzend wirkenden Verbindung die für solche Reaktionen an sich bekannten Säuren und Basen eingesetzt werden. Allerdings ist dabei zu beachten, daß sich damit im allgemeinen der Verarbeitungsspielraum bei der Entwicklung der Schicht (S) einengt, so daß die Menge an Katalysatoren im allgemeinen gering gehalten wird. Teilweise ist bereits der Zusatz von Katalysatormengen in ppm-Bereich hinreichend. Als Beispiele für basische Katalysatoren seien genannt : Benzyldimethylamin, Benzyltrimethylammoniumhydroxyd, Diazabicyclooctan, N,N,N',N'-Tetramethyl-1,3-diaminobutan, 2-Dimethylamino-2-hydroxypropan, 2-Dimethylaminomethyl-phenol, 2,4,6-Tri-(dimethylaminoethyl)-phenol, zinnorganische Verbindungen, wie Zinnoctoat u. a.

Beispiele für Sensibilisatoren sind : Xanthen-Farbstoffe, wie Fluorescein, Eosin und Rhodamin S, sowie Triplet-Energieüberträger, wie sie beispielsweise N. J. Turro in seinem Buch « Moleculare Photochemistry, W. A. Benjamin Inc., New York 1967, auf Seite 132 beschreibt. Als Farbstoffe, die in der lichtempfindlichen Schicht (S) enthalten sein können, haben sich u. a. Sudanfarbstoffe, Polymethin-Farbstoffe, Azofarbstoffe, Phthalocyanin-Farbstoffe oder Dispersionsfarbstoffe sowie Eosin, Kristallviolett oder Malachitgrün bewährt. Besonders vorteilhaft sind solche Farbstoffe, die bei der Belichtung mit aktinischem Licht ihre Färbung reversibel oder irreversibel ändern. So werden z. B. Sudanfarbstoffe, Polymethinfarbstoffe oder Azofarbstoffe durch zugesetzte Photoinitiatoren, wie Benzoinether, Benzilketale, Benzophenon oder Michlers' Keton in der lichtempfindlichen Schicht (S) entsprechend der bildmäßigen Belichtung ausgebleicht. Besonders erwähnt seien die Polymethinfarbstoffe der allgemeinen Formel (II) :

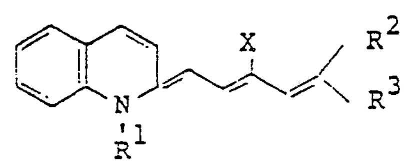

(II)

worin bedeuten : $R^1$ Alkyl, $R^2$—CN ; $R^3$—CN, —$COOR^4$, —Ph—$R^5$ ; $R^4$ Alkyl ; $R^5$—$NO_2$, Halogen, Alkyl, Alkoxy ; X Halogen.

Gemäß einer besonderen Ausführungsform der Erfindung kann die lichtempfindliche Schicht (S) als Zusatzstoffe feinteilige Füllstoffe, insbesondere feinteilige abräsive Füllstoffe enthalten, wie es in der EP-A1-70511 beschrieben ist. Durch Zusatz dieser feinteiligen abräsiven Füllstoffe kann insbesondere die Härte der Schicht (S) und damit die Kratz- und Abriebfestigkeit der hergestellten Tiefdruckformen erhöht

werden. Darüber hinaus können durch geeignete Füllstoffe auch sonstige Eigenschaften der Schicht (S), z. B. Fließeigenschaften, Steifigkeit etc., verbessert werden. Die mittlere Teilchengröße der feinteiligen Füllstoffe liegt vorzugsweise im Bereich von 0,1 bis 6 µm, wobei vorteilhafterweise bei höchstens 5 %, vorzugsweise bei weniger als 1 % der feinteiligen Füllstoffe die größte Längenausdehnung > 10 µm beträgt. Werden der lichtempfindlichen Schicht (S) feinteilige abräsive Füllstoffe zugesetzt, so soll deren Härte im allgemeinen > 4,0 auf der Mohs'schen Härteskala betragen. Vorteilhaft liegt die Härte der abräsiven Füllstoffe bei 6 oder mehr der Mohs'schen Härteskala. Bei diesen Füllstoffen handelt es sich insbesondere um mineralische Füllstoffe und Pigmente, wie z. B. Siliciumdioxide, insbesondere Quarzmehl und Kristobalit ; Silikate, insbesondere Aluminiumsilikate, Silikatgläser ; Aluminiumoxide, insbesondere Korund ; Titandioxid, Siliciumcarbid, Wolframcarbid u. a. Die feinteiligen Füllstoffe, insbesondere die feinteiligen abräsiven Füllstoffe, können in der gesamten lichtempfindlichen Schicht (S) enthalten sein ; zur Herstellung von Tiefdruckformen mit den gewünschten Eigenschaften ist es häufig jedoch schon hinreichend, wenn die Füllstoffe nur in einer dünnen Oberflächenzone von etwa 1 bis 50 µm, vorzugsweise von 5 bis 20 µm Dicke, gemessen von der Oberfläche der Schicht (S), die die spätere Oberfläche der Druckschicht bildet, enthalten sind.

Wie bereits erwähnt, wird die lichtempfindliche Schicht (S) zunächst auf den Druckformträger nach den bekannten Auftragstechniken, beispielsweise durch Gießen der lichtempfindlichen Schicht (S) aus Lösung, aufgebracht. Bei Einsatz von plattenförmigen Druckformträgern für die Herstellung der Druckplatten hat es sich als günstig erwiesen, die lichtempfindliche Schicht (S) auf den plattenförmigen Druckformträger aufzulaminieren, indem man beispielsweise die lichtempfindliche Schicht (S) zunächst auf einem temporären Träger erzeugt und dann unter Anwendung von Druck und/oder Wärme auf den plattenförmigen Druckformträger überträgt. Die lichtempfindliche Schicht (S) wird vorteilhafterweise derart hergestellt, daß die Oberfläche der Schicht (S), die die spätere Oberfläche der Druckschicht darstellt, insbesondere eine Rauhtiefe < 2 µm, vorzugsweise < 1 µm besitzt.

Wird die lichtempfindliche Schicht (S) durch Laminieren auf den Druckformträger aufgebracht, so kann es günstig sein, die Schicht (S) vor dem Auflaminieren kurzzeitig vollflächig mit aktinischem Licht vorzubelichten. Diese Vorbelichtung geschieht bevorzugt auf der Seite der lichtempfindlichen Schicht (S), die später auf den Druckformträger aufgebracht wird und kann bis zu 70 % der Zeit für die nachfolgende bildmäßige Hauptbelichtung betragen. Diese Vorbelichtung führt u. a. zu einer verbesserten Haftung der lichtempfindlichen Schicht (S) auf metallischen Druckformträgern.

Zur Herstellung der Tiefdruckformen wird erfindungsgemäß die lichtempfindliche Schicht (S) durch eine geeignete Bildvorlage mit aktinischem Licht in an sich bekannter Weise bildmäßig belichtet. Geeignete Lichtquellen hierfür sind solche, die aktinisches Licht im Wellenlängenbereich von 200 bis 600 nm, vorzugsweise im Bereich von 300 bis 420 nm, ausstrahlen, also z. B. Kohlebogenlampen, Quecksilberhochdrucklampen, Xenonhochdrucklampen und insbesondere Quecksilberniederdruckfluoreszenzlampen. Die Belichtungszeiten für die bildmäßige Belichtung liegen im allgemeinen im Bereich von etwa 0,05 bis 50 Minuten. In einer besonders vorteilhaften Ausführungsform kann die bildmäßige Belichtung der lichtempfindlichen Schicht (S) mit einem gesteuerten und modulierten aktinischen Laserstrahl, z. B. einem UV-Laser vorgenommen werden.

Ein besonderer Vorteil des erfindungsgemäßen Verfahrens besteht in seiner großen Variabilität, die es erlaubt, je nach gegebenen Bedingungen und Anforderungen beliebige bildmäßige Vorlagen zu benutzen. So kann die bildmäßige Belichtung in dem erfindungsgemäßen Verfahren sowohl durch ein Raster- oder Strich-Positiv oder auch durch ein Raster- oder Strich-Negativ erfolgen. Gleichermaßen ist es z. B. möglich, die lichtempfindliche Schicht (S) gleichzeitig durch ein Halbton-Negativ und ein Raster- oder Strich-Negativ zu belichten.

Je nach Wahl der Bildvorlage für die bildmäßige Belichtung kann die Reihenfolge der nachfolgenden Verfahrensschritte in dem erfindungsgemäßen Verfahren unterschiedlich sein. Wird die lichtempfindliche Schicht (S) beispielsweise durch ein Raster- oder Strich-Negativ belichtet, so werden die belichteten Anteile zunächst mit einem wäßrigen Entwicklerlösungsmittel ausgewaschen. Die Stabilität, Abrieb- und Kratzfestigkeit der Schicht (S) wird darauf durch eine vollflächige Nachbelichtung der Schicht (S) mit aktinischem Licht und eine nachfolgende thermische Härtung und Vernetzung der Schicht (S) erhöht. Durch die vollflächige Nachbelichtung werden in den nicht ausgewaschenen Schichtteilen die o-Nitrocarbinolestergruppierungen unter Bildung von Carboxylgruppen gespalten, die dann mit der vernetzend wirkenden Verbindung bei erhöhter Temperatur reagieren, wodurch der Schicht (S) verbesserte mechanische Stabilität und Lösungsmittelresistenz verliehen wird. Nach dieser Verfahrensweise erhält man eine autotypische Tiefdruckform. Falls eine Tiefdruckform mit tiefenvariablen Näpfchen erwünscht wird, kann ein gleichzeitiges Belichten der Schicht durch ein Halbton-Negativ sowie ein Raster- oder Strich-Negativ erfolgen, wobei die nachfolgenden Verfahrensschritte wie oben beschrieben durchgeführt werden.

Wird die lichtempfindliche Schicht (S) durch ein Raster- oder Strich-Positiv belichtet, werden die belichteten Bereiche zunächst selektiv thermisch gehärtet und vernetzt. Die nicht vernetzten Bereiche der Schicht (S) können danach direkt mit einem geeigneten Entwicklerlösungsmittel ausgewaschen werden ; vorteilhafterweise wird die Schicht (S) jedoch zunächst noch einmal vollflächig mit aktinischem Licht nachbelichtet und dann mit einem wäßrigen Entwicklerlösungsmittel ausgewaschen. Im letzten Fall kann in einer besonderen Ausgestaltungsform des erfindungsgemäßen Verfahrens die Schicht (S) nach dem

Auswaschen mit dem wäßrigen Entwicklerlösungsmittel noch einmal nachgehärtet und nachvernetzt werden.

Es kann auch eine Kombination dieser beiden Verfahrensvarianten verwendet werden, indem die nicht druckenden Bereiche und Stege zunächst durch ein Raster- oder Strich-Positiv belichtet werden, anschließend diese belichteten Bereiche selektiv thermisch gehärtet und vernetzt werden, worauf durch eine Belichtung durch ein Halbton- oder Raster-Negativ und durch Auswaschen und Härten der Schicht (S) die Näpfchen gebildet werden.

Als Entwickler-Lösungsmittel werden in dem erfindungsgemäßen Verfahren insbesondere wäßrige Entwickler-Lösungsmittel eingesetzt. Hierbei kann es sich um Wasser als solches oder auch um Mischungen von Wasser mit wasserlöslichen, organischen Lösungsmitteln handeln, beispielsweise um Gemische von Wasser mit aliphatischen Alkoholen, insbesondere Methanol oder Ethanol ; Ketonen, wie z. B. Aceton ; oder cyclischen Ethern, z. B. Tetrahydrofuran. Insbesondere wird als Entwicklerlösungsmittel Wasser eingesetzt. Der pH-Wert des Entwicklerlösungsmittels ist zweckmäßig größer als 7,5, wodurch wenigstens ein Teil der freien Carboxylgruppen in die Salzform übergeführt wird. Die optimale Alkalimenge bzw. der pH-Wert ist dabei natürlich von dem verwendeten Schichtmaterial und der Belichtungsdauer und -intensität, also der Menge der durch die Belichtung gebildeten freien Carboxyl-Gruppen abhängig. Als Alkalien für das Entwicklerlösungsmittel können z. B. Zusätze von Borax, Dinatriumhydrogenphosphat, Soda, Alkalihydroxiden oder von organischen Basen, wie Di- oder Triethanolamin, verwendet werden. Der Auswaschlösung können auch Zusätze, wie beispielsweise oberflächenaktive Substanzen, Natriumcarboximethylcellulose, Polyvinylalkohol, Polynatriumacrylat und dergleichen zugegeben werden. Das Auswaschen der Schicht (S) kann dabei in üblicher Weise, beispielsweise durch Besprühen, Ausreiben oder Ausbürsten mit dem wäßrigen Entwicklerlösungsmittel geschehen. Zur Beschleunigung des Entwicklungs-Vorganges können, in Abhängigkeit von der in der Schicht (S) enthaltenen vernetzend wirkenden Verbindung, erhöhte Temperaturen, beispielsweise bis etwa 40 °C angewandt werden. Die Entwicklungsdauer liegt im allgemeinen im Bereich von einigen Minuten.

Für die vollflächige Nachbelichtung der Schicht (S) können die gleichen Lichtquellen herangezogen werden wie für die vorerwähnte bildmäßige Belichtung. Die Dauer der vollflächigen Nachbelichtung liegt im allgemeinen im Bereich von 0,05 bis 50 Minuten. Ganz allgemein wird sie mit einer solchen Intensität und für eine solche Dauer durchgeführt, daß hierdurch in der Schicht (S) eine hinreichende Anzahl von freien Carboxylgruppen gebildet werden, wie sie für die nachfolgende thermische Härtung und Vernetzung bzw. das nachfolgende Auswaschen mit dem wäßrigen Entwicklerlösungsmittel notwendig sind.

Die thermische Härtung und Vernetzung der Schicht (S) kann bei Raumtemperatur erfolgen, jedoch sind dann im allgemeinen sehr lange Härtungszeiten notwendig. Vorteilhafterweise wird daher die Härtung und Vernetzung bei erhöhten Temperaturen durchgeführt, indem die Schicht (S) auf Temperaturen im Bereich von vorzugsweise 50 bis 250 °C, insbesondere 60 bis 200 °C, erwärmt wird. Die Dauer für die Härtung und Vernetzung, die im Bereich von etwa 10 Minuten bis einigen Stungen, z. B. 5 Stunden, liegen kann, ist u. a. abhängig von der Art und Reaktivität der eingesetzten vernetzend wirkenden Verbindungen, der Anzahl der bei der Belichtung erzeugten freien Carboxylgruppen, dem gewünschten Vernetzungs- und Härtungsgrad etc. Beispielsweise erfordert die Vernetzung der freien Carboxylgruppen mit Epoxidverbindungen relativ hohe Härtungstemperaturen. So muß man beispielsweise ein äquimolares unkatalysiertes Gemisch aus Carbonsäure und einem Diepoxid aus 2,2-Bis(p-hydroxyphenyl)-propan 2 bis 4 Stunden auf etwa 150 bis 200 °C erhitzen, um alle Epoxidgruppen umzusetzen. Man kann die Härtung, beispielsweise unter Einsatz eines Überschusses oder auch Unterschusses an Epoxidverbindungen bzw. ganz allgemein den vernetzend wirkenden Verbindungen, auch stufenweise vornehmen, indem man beispielsweise zunächst auf Temperaturen bis etwa 150 °C erwärmt und anschließend bei Temperaturen über 150 °C, insbesondere bei Temperaturen um 200 °C oder darüber, endgültig aushärtet. Die thermische Härtung und Vernetzung der Schicht (S) wird im allgemeinen derart durchgeführt, daß die Schicht (S) in den nicht druckenden Bereichen üblicher Weise eine unter Last gemessene Vickers-Härte von mindestens 10 $N/mm^2$, vorzugsweise von mindestens 50 $N/mm^2$ und insbesondere von mindestens 100 $N/mm^2$, aufweist. Die Methode zur Ermittlung der unter Last gemessenen Vickers-Härte ist beschrieben in der Zeitschrift « Kunststoffe », Band 60 (1970), Seiten 265 bis 273.

Die erfindungsgemäß hergestellten Tiefdruckformen weisen nicht nur eine hohe Härte auf, sie sind auch sehr abriebfest und erlauben den Druck hoher Auflagen bei minimalen Abrieb. Oberflächenkratzer können wegpoliert werden. Stahlrakeln können benutzt werden, ohne daß das Druckbild beeinflussende Beschädigungen der Oberfläche der Tiefdruckform eintreten. Die erfindungsgemäß hergestellten Tiefdruckformen weisen ferner eine verbesserte Resistenz gegen Druckfarben auf, auch gegenüber alkoholischen Druckfarben. Ein besonderer Vorteil der erfindungsgemäß hergestellten Tiefdruckformen ist, daß sie bei einfacher und preisgünstiger Herstellung mit konventionellen Tiefdruckmaschinen verarbeitbar sind. Sie geben auch bei hoher Auflagenhöhe (500 000 bis 1 000 000) gute Druckqualitäten auch hinsichtlich der Halbtonwiedergabe.

Die nachstehenden Beispiele erläutern die Erfindung. Die in den Beispielen angegebenen Teile beziehen sich, sofern nicht anders vermerkt, auf das Gewicht.

Beispiel 1

72 Teile eines Methylmethacrylat-Copolymerisats, welches 25 Teile o-Nitrobenzylacrylat einpolymerisiert enthielt, 27 Teile eines Bisphenol-A-diglycidylethers (®Epikote 828 der Firma Shell), 0,7 Teile Benzildimethylketal, 0,1 Teile eines schwarzen Farbstoffes und 0,2 Teile des Polymethinfarbstoffes der allgemeinen Formel (II), worin $R^1$ eine Methylgruppe, $R^2$ eine Nitrilgruppe, $R^3$ eine —COOEt-Gruppe und X Chlor darstellt, wurden in 160 Vol.-Teilen Essigsäureethylester gelöst. Aus dieser Lösung wurde auf eine Polyethylenterephthalatfolie (temporärer Träger) eine lichtempfindliche Schicht so gegossen, daß nach Entfernung des Lösungsmittels und Trocknen eine Schichtdicke von etwa 50 µm resultierte. Die freie Oberfläche der so hergestellten lichtempfindlichen Schicht wurde bei 100 °C auf eine Kupferplatte auflaminiert. Nach Abziehen der Polyester-Folie wurde die lichtempfindliche Schicht durch ein Raster-Negativ mit aktinischem Licht belichtet. Die belichteten Bildteile wurden mit einem Entwicklerlösungsmittel aus 81 % Wasser, 16 % 2-Butoxyethanol und 3 % Triethanolamin in 20 Minuten ausgewaschen. Anschließend wurde die ausgewaschene Platte vollflächig nachbelichtet und mit steigender Temperatur getempert, je 1 Stunde bei 60 °C, 80 °C, 120 °C und 150 °C.

Die so hergestellte Tiefdruckform gab ein einwandfreies Druckbild. Die Druckform wurde in einem Abriebtester des Typs AT II der Firma Burda geprüft. Nach einer Million Rakelzyklen war die Druckform kaum beschädigt und gab noch ein gutes Druckbild.

Beispiel 2

Es wurde wie in Beispiel 1 gearbeitet, die lichtempfindliche Schicht diesmal jedoch durch ein Raster-Positiv belichtet. Anschließend wurde die Schicht mit steigender Temperatur getempert (je eine Stunde bei 60 °C, 80 °C, 120 °C und 150 °C), um die belichteten Schichtanteile zu vernetzen. Die getemperte Schicht wurde vollflächig nachbelichtet und die nicht vernetzten Anteile mit dem gleichen Entwicklerlösungsmittel wie in Beispiel 1 entfernt. Danach wurde die Druckform nochmals eine Stunde bei 150 °C getempert.

Die Druckform wurde in einem Abriebtester des Typs AT II der Firma Burda geprüft. Nach einer Million Rakelzyklen war die Druckform kaum beschädigt und gab ein sehr gutes Druckbild.

Beispiel 3

Es wurde wie in Beispiel 1 gearbeitet, die lichtempfindliche Schicht diesmal jedoch gleichzeitig durch ein Raster-Negativ und ein Halbton-Negativ belichtet. Die anschließende Weiterverarbeitung erfolgte wie in Beispiel 1 beschrieben. Die Näpfchen der fertigen Tiefdruckform waren in Abhängigkeit der Tonwerte unterschiedlich tief ausgebildet. Die Tiefdruckform gab ausgezeichnete Druckergebnisse, insbesondere auch eine sehr gute Halbton-Wiedergabe.

Beispiel 4

Es wurde wie in Beispiel 1 gearbeitet, die lichtempfindliche Schicht diesmal jedoch aus 65 Teilen des Methylmethacrylat-Copolymerisats aus Beispiel 1, 25 Teilen ®Epikote 828 und 10 Teilen Quarzmehl (Teilchengröße 10 µ) hergestellt. Die Belichtung, Entwicklung und Härtung der lichtempfindlichen Schicht erfolgt wie in Beispiel 1 beschrieben. Die so gewonnene Tiefdruckform war nach einer Million Rakelzyklen im Abriebstester des Typs AT II der Firma Burda völlig unbeschädigt.

**Patentansprüche**

1. Verfahren zur Herstellung von Tiefdruckformen mit einer auf einem Druckformträger aufgebrachten Kunststoff-Druckschicht durch bildmäßiges Belichten mit aktinischem Licht einer auf dem Druckformträger haftfest aufgebrachten festen, lichtempfindlichen Schicht (S), Auswaschen der belichteten Schicht (S) mit einem Entwicklerlösungsmittel und thermisches Härten dieser Schicht (S) zur Ausbildung der Kunststoff-Druckschicht, dadurch gekennzeichnet, daß die lichtempfindliche Schicht (S) als lichtempfindliche Komponente eine Verbindung mit mindestens 2 aromatischen und/oder heteroaromatischen o-Nitrocarbinolestergruppierungen der allgemeinen Formel (I)

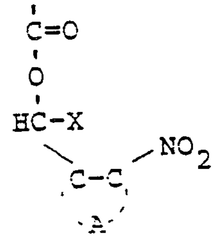

(I)

enthält, worin

A den Rest eines aromatischen oder heteroaromatischen, gegebenenfalls substituierten Ringsystems mit 5 bis 14 Ringgliedern und

X ein Wasserstoffatom, einen Alkylrest mit 1 bis 8 Kohlenstoffatomen oder einen gegebenenfalls substituierten Aryl- oder Aralkylrest bedeutet, und daß die lichtempfindliche Schicht (S) eine vernetzend wirkende Verbindung mit mindestens zwei reaktiven Gruppen enthält, die unter dem Einfluß von Wärme mit —COOH-Gruppen unter Bildung einer kovalenten chemischen Bindung zu reagieren vermögen, und daß die lichtempfindliche Schicht (S) nach dem bildmäßigen Belichten entweder mit einem wäßrigen Entwicklerlösungsmittel ausgewaschen, anschließend vollflächig mit aktinischem Licht nachbelichtet und darauf thermisch vernetzt und gehärtet wird oder zunächst in den belichteten Bereichen selektiv thermisch gehärtet und vernetzt, anschließend entweder direkt mit einem Lösungsmittel entwickelt oder vollflächig mit aktinischem Licht nachbelichtet und darauf mit einem wäßrigen Entwicklerlösungsmittel ausgewaschen wird.

2. Verfahren nach Anspruch 1, dadurch gekennzeichnet, daß die lichtempfindliche Schicht (S) eine Verbindung mit o-Nitrocarbinolestergruppierungen der allgemeinen Formel (I) enthält, in der das den o-Nitrocarbinolestergruppierungen der Formel (I) zugrundeliegende Carbinol o-Nitrobenzylalkohol, 2-Nitro-6-chlorbenzylalkohol, 2-Nitro-4-cyanbenzylalkohol, 2-Nitro-4,5-dimethoxybenzylalkohol, α-Methyl-o-nitrobenzylalkohol, α-Phenyl-o-nitrobenzylalkohol oder α-(o-Nitrophenyl)-o-nitrobenzylalkohol ist.

3. Verfahren nach Ansprüchen 1 und 2, dadurch gekennzeichnet, daß die lichtempfindliche Schicht (S) als Verbindung mit den o-Nitrocarbinolestergruppierungen der Formel (I) einen Di- und/oder Polyester einer niedermolekularen Di- und/oder Polycarbonsäure sowie zusätzlich ein mit diesen Estern verträgliches polymeres Bindemittel enthält.

4. Verfahren nach Ansprüchen 1 und 2, dadurch gekennzeichnet, daß die lichtempfindliche Schicht (S) ein Polymeres mit einem Molekulargewicht > 500 enthält, welches zumindest 5 Gew.-%, bezogen auf das Molekulargewicht des Polymeren, aromatische und/oder heteroaromatische o-Nitrocarbinolestergruppierungen der allgemeinen Formel (I) im Molekül gebunden enthält.

5. Verfahren nach Anspruch 4, dadurch gekennzeichnet, daß die lichtempfindliche Schicht (S) ein o-Nitrocarbinolestergruppierungen der Formel (I) tragendes Polymeres enthält, welches sich von einem Homo- oder Copolymerisat der Acrylsäure, Methacrylsäure, Maleinsäure, Fumarsäure und/oder Crotonsäure ableitet.

6. Verfahren nach einem der Ansprüche 1 bis 5, dadurch gekennzeichnet, daß die lichtempfindliche Schicht (S) eine Verbindung, insbesondere ein Polymeres, enthält, welche neben den o-Nitrocarbinolestergruppierungen der Formel (I) gleichzeitig die vernetzend wirkenden, reaktiven gruppen im Molekül eingebaut enthält.

7. Verfahren nach Anspruch 6, dadurch gekennzeichnet, daß die o-Nitrocarbinolestergruppierungen der Formel (I) enthaltende Verbindung zusätzlich Amin-, Imin, Amid-, Epoxid-, Hydroxyd-, Isocyanat- und/oder verkappte Isocyanat-Gruppen eingebaut enthält.

8. Verfahren nach einem der Ansprüche 1 bis 5, dadurch gekennzeichnet, daß die lichtempfindliche Schicht (S) neben der Verbindung mit den o-Nitrocarbinolestergruppierungen der Formel (I) zusätzlich eine oder mehrere vernetzend wirkende Verbindungen mit mindestens zwei reaktiven Gruppen der genannten Art enthält.

9. Verfahren nach Anspruch 8, dadurch gekennzeichnet, daß die lichtempfindliche Schicht (S) als vernetzend wirkende Verbindung Epoxide, Isocyanate, verkappte Isocyanate, α,ω-Diisocyanatopolycarbodiimide, Alkohole und/oder Amine enthält.

10. Verfahren nach einem der Ansprüche 1 bis 9, dadurch gekennzeichnet, daß die Dicke der lichtempfindlichen Schicht (S) im Bereich von 5 bis 500 µm liegt.

11. Verfahren nach einem der Ansprüche 1 bis 10, dadurch gekennzeichnet, daß die lichtempfindliche Schicht (S) weitere Zusatz- und/oder Hilfsstoffe enthält.

12. Verfahren nach Anspruch 11, dadurch gekennzeichnet, daß die lichtempfindliche Schicht (S) Weichmacher, Verlaufsmittel, Katalysatoren für die thermische Härtung, Sensibilisatoren, Farbstoffe, Pigmente und/oder fotochrome Substanzen enthält.

13. Verfahren nach Anspruch 11, dadurch gekennzeichnet, daß die lichtempfindliche Schicht (S) zumindest in einer Oberflächenzone von 1 bis 50 µm feinteilige Füllstoffe enthält.

14. Verfahren nach Anspruch 13, dadurch gekennzeichnet, daß die feinteiligen Füllstoffe eine mittlere Teilchengröße im Bereich von 0,1 bis 6µm und eine Härte > 4,0 auf der Mohs'schen Härteskala besitzen.

15. Verfahren nach einem der Ansprüche 1 bis 14, dadurch gekennzeichnet, daß die thermische Vernetzung und Härtung der mit aktinischem Licht belichteten Schicht (S) bei Temperaturen im Bereich von 50 bis 250 °C vorgenommen wird.

16. Verfahren nach einem der Ansprüche 1 bis 15, dadurch gekennzeichnet, daß die lichtempfindliche Schicht (S) durch ein Raster- oder Strich-Negativ bildmäßig mit aktinischem Licht belichtet wird, anschließend die belichteten Anteile der Schicht (S) mit einem wäßrigen Entwicklerlösungsmittel ausgewaschen werden, worauf die Schicht (S) vollflächig mit aktinischem Licht nachbelichtet und danach thermisch gehärtet und vernetzt wird.

17. Verfahren nach Anspruch 16, dadurch gekennzeichnet, daß die lichtempfindliche Schicht (S) gleichzeitig durch ein Halbton-Negativ und ein Raster- oder Strich-Negativ belichtet wird.

18. Verfahren nach einem der Ansprüche 1 bis 15, dadurch gekennzeichnet, daß die lichtempfindliche Schicht (S) durch ein Raster- oder Strich-Positiv bildmäßig mit aktinischem Licht belichtet wird, anschließend die belichteten Bereiche selektiv thermisch gehärtet und vernetzt werden und danach die nicht gehärteten und nicht vernetzten Bereiche der Schicht (S) mit einem Entwicklerlösungsmittel ausgewaschen werden.

19. Verfahren nach Anspruch 18, dadurch gekennzeichnet, daß die lichtempfindliche Schicht (S) nach dem selektiven Härten und Vernetzen der bildmäßig belichteten Bereiche vollflächig mit aktinischem Licht nachbelichtet und darauf mit einem wäßrigen Entwicklerlösungsmittel ausgewaschen wird.

20. Verfahren nach einem der Ansprüche 1 bis 15, dadurch gekennzeichnet, daß die lichtempfindliche Schicht (S) zunächst durch ein Raster- oder Strich-Positiv bildmäßig mit aktinischem Licht belichtet wird, anschließend die belichteten Bereiche der Schicht (S) selektiv thermisch gehärtet und vernetzt werden, worauf die lichtempfindliche Schicht (S) durch ein Halbton- oder Raster-Negativ noch einmal mit aktinischem Licht bildmäßig belichtet wird, danach die bei der zweiten bildmäßigen Belichtung belichteten Bereiche der Schicht (S) mit einem wäßrigen Entwicklerlösungsmittel ausgewaschen werden und schließlich die Schicht (S) vollflächig mit aktinischem Licht nachbelichtet und thermisch gehärtet und vernetzt wird.

21. Verfahren nach einem der Ansprüche 1 bis 20, dadurch gekennzeichnet, daß die Belichtung der lichtempfindliche Schicht (S) mit einem gesteuerten und modulierten aktinischen Laserstrahl vorgenommen wird.

**Claims**

1. A process for the production of a gravure printing plate having a plastic printing layer applied to a printing plate base, by subjecting a solid photosensitive layer (L), which is firmly bonded to the said base, to image-wise exposure to actinic light, washing out the exposed layer (L) with a developer and subjecting this layer (L) to thermal hardening to form the plastic printing layer, wherein the photosensitive layer (L) contains, as the photosensitive component, a compound possessing two or more aromatic and/or heteroaromatic o-nitrocarbinol ester groups of the general formula (I)

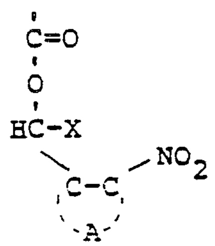

(I)

where

A is a radical of an unsubstituted or substituted 5-membered to 14-membered aromatic or heteroaromatic ring system, and

X is hydrogen, alkyl of 1 to 8 carbon atoms or an unsubstituted or substituted aryl or aralkyl radical, and wherein the photosensitive layer (L) contains a compound which effects crosslinking and possesses two or more reactive groups, which, under the action of heat, are capable of reactive with —COOH groups to form a covalent chemical bond, and the photosensitive layer (L) is exposed imagewise and then either washed out with an aqueous developer, post-exposed uniformly to actinic light and then subjected to thermal hardening and crosslinking, or first subjected to selective thermal hardening and crosslinking in the exposed areas and then either developed directly with a solvent or post-exposed uniformly to actinic light and thereafter washed out with an aqueous developer.

2. A process as claimed in claim 1, wherein the photosensitive layer (L) contains a compound possessing o-nitro-carbinol ester groups of the formula (I), in which the carbinol on which the o-nitrocarbinol ester groups of the formula (I) are based is o-nitrobenzyl alcohol, 2-nitro-6-chlorobenzyl alcohol, 2-nitro-4-cyanobenzyl alcohol, 2-nitro-4,5-dimethoxybenzyl alcohol, α-methyl-o-nitrobenzyl alcohol, α-phenyl-o-nitrobenzyl alcohol or α-(o-nitrophenyl)-o-nitrobenzyl alcohol.

3. A process as claimed in claims 1 and 2, wherein the photosensitive layer (L) contains, as the compound possessing the o-nitrocarbinol ester groups of the formula (I), a di- and/or polyester of a low molecular weight di- and/or polycarboxylic acid and in addition a polymeric binder which is compatible with these esters.

4. A process as claimed in claims 1 and 2, wherein the photosensitive layer (L) contains a polymer which has a molecular weight of above 500 and contains not less than 5 % by weight, based on the molecular weight of the polymer, of aromatic and/or heteroaromatic o-nitrocarbinol ester groups of the formula (I) bonded in the molecule.

5. A process as claimed in claim 4, wherein the photosensitive layer (L) contains a polymer which possesses o-nitrocarbinol ester groups of the formula (I) and is derived from a homopolymer or copolymer of acrylic acid, methacrylic acid, maleic acid, fumaric acid and/or crotonic acid.

6. A process as claimed in claims 1 to 5, wherein the photosensitive layer (L) contains a compound, in particular a polymer, which, in addition to the o-nitrocarbinol ester groups of the formula (I), also contains the crosslinking reactive groups incorporated in the molecule.

7. A process as claimed in claim 6, wherein the compound possessing o-nitrocarbinol ester groups of the formula (I) additionally contains amine, imine, amide, epoxide, hydroxyl, isocyanate and/or blocked isocyanate groups.

8. A process as claimed in any of claims 1 to 5, wherein the photosensitive layer (L) contains, in addition to the compound possessing the o-nitrocarbinol ester groups of the formula (I), one or more crosslinking compounds possessing two or more reactive groups of the type mentioned.

9. A process as claimed in claim 8, wherein the photosensitive layer (L) contains, as crosslinking compounds, epoxides, isocyanates, blocked isocyanates, $\alpha,\omega$-diisocyanatopolycarbodiimides, alcohols and/or amines.

10. A process as claimed in any of claims 1 to 9, wherein the photosensitive layer (L) is from 5 to 500 $\mu$ thick.

11. A process as claimed in any of claims 1 to 10, wherein the photosensitive layer (L) contains further additives and/or assistants.

12. A process as claimed in claim 11, wherein the photosensitive layer (L) contains plasticizers, flow improvers, catalysts for thermal hardening, sensitizers, dyes, pigments and/or photochromic substances.

13. A process as claimed in claim 11, wherein the photosensitive layer (L) contains, in a surface zone of from 1 to 50 $\mu$m, or throughout, a finely divided filler.

14. A process as claimed in claim 13, wherein the finely divided filler has a mean particle size of from 0.1 to 6 $\mu$m and a hardness $> 4.0$ on Mohs' hardness scale.

15. A process as claimed in any of claims 1 to 14, wherein thermal hardening and crosslinking of the layer (L) which has been exposed to actinic light is carried out at from 50 to 250 °C.

16. A process as claimed in any of claims 1 to 15, wherein the photosensitive layer (L) is exposed imagewise to actinic light through a halftone negative or line negative, the exposed areas of the layer (L) are washed out with an aqueous developer, and the layer (L) is post-exposed uniformly to actinic light and then subjected to thermal hardening and crosslinking.

17. A process as claimed in claim 16, wherein the photosensitive layer (L) is exposed through a continuous tone negative and a halftone negative or line negative simultaneously.

18. A process as claimed in any of claims 1 to 15, wherein the photosensitive layer (L) is exposed imagewise to actinic light through a halftone positive or line positive, the exposed areas are subjected to selective thermal hardening and crosslinking and the non-hardened and noncrosslinked areas of the layer (L) are then washed out with a developer.

19. A process as claimed in claim 18, wherein the photosensitive layer (L), after selective hardening and crosslinking of the imagewise exposed areas, is post-exposed uniformly to actinic light and then washed out with an aqueous developer.

20. A process as claimed in any of claims 1 to 15, wherein the photosensitive layer (L) is first exposed imagewise to actinic light through a halftone positive or line positive, the exposed areas of the layer (L) are subjected to selective thermal hardening and crosslinking, the photosensitive layer (L) is then exposed imagewise to actinic light through a continuous tone negative or halftone negative, the areas of the layer (L) which have been exposed during the second imagewise exposure are washed out with an aqueous developer and finally the layer (L) is post-exposed uniformly to actinic light and subjected to thermal hardening and crosslinking.

21. A process as claimed in any of claims 1 to 20, wherein exposure of the photosensitive layer (L) is carried out using a controlled and modulated actinic laser beam.

**Revendications**

1. Procédé de fabrication de formes pour l'impression en héliogravure avec une couche d'impression en matière plastique appliquée sur un support de la forme par exposition à la lumière actinique suivant une image d'une couche photosensible (S) solide, adhérant solidement au support de la forme, traitement de la couche (S) exposée par un solvant révélateur et durcissement thermique de cette couche (S) pour l'obtention de la couche d'impression en matière plastique, caractérisé en ce que la couche photosensible (S) contient comme substance photosensible un composé comprenant au moins deux groupements ester d'o-nitro-carbinol aromatiques et(ou) hétéro-aromatiques de la formule générale (I)

(Voir dessin p. 14)

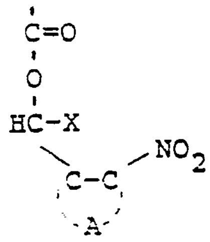

(I)

dans laquelle

A désigne le reste d'un système cyclique aromatique ou hétéro-aromatique avec cinq à quatorze chaînons, éventuellement substitué, et

X un atome d'hydrogène, un radical alkyle en $C_1$ à $C_8$ ou un groupe aryle ou aralkyle éventuellement substitué, et un composé à action réticulante, comportant au moins deux groupes réactifs, capables de réagir sous l'effet de la chaleur avec des groupes —COOH avec formation d'une liaison chimique covalente, cette couche photosensible (S) étant exposée à la lumière suivant une image, puis traitée avec un solvant révélateur aqueux, puis soumis à une post-exposition à la lumière actinique sur toute sa surface et ensuite réticulée et durcie par voie thermique, ou exposée à la lumière suivant une image, les régions exposées étant réticulées et durcies sélectivement par voie thermique, puis la couche est développée directement par un solvant ou soumise d'abord sur toute sa surface à une post-exposition à la lumière actinique et ensuite traitée avec un solvant révélateur aqueux.

2. Procédé suivant la revendication 1, caractérisé en ce que la couche photosensible (S) contient un composé à groupements ester d'o-nitro-carbinol de la formule générale (I), qui dérivent de l'alcool o-nitro-benzylique, de l'alcool nitro-2 chloro-6 benzylique, de l'alcool nitro-2 cyano-4 benzylique, de l'alcool nitro-2 diméthoxy-4,5 benzylique, de l'alcool α-méthyl-o-nitro-benzylique, de l'alcool-α-phényl-o-nitro-benzylique ou de l'alcool α-(o-nitro-phényl)-o-nitro-benzylique.

3. Procédé suivant les revendications 1 et 2, caractérisé en ce que la couche photosensible (S) contient comme composé à groupements ester d'o-nitro-carbinol de la formule (I) un di- et(ou) un polyester d'un acide di- et(ou) poly-carboxylique de bas poids moléculaire, ainsi qu'un liant polymère compatible avec ces esters.

4. Procédé suivant les revendications 1 et 2, caractérisé en ce que la couche photosensible (S) contient un polymère d'un poids moléculaire supérieur à 500, dans lequel sont copolymérisés au moins 5 % en poids par rapport au poids moléculaire du polymère de groupements ester d'o-nitro-carbinol aromatiques et(ou) hétéro-aromatiques de la formule générale (I).

5. Procédé suivant la revendication 4, caractérisé en ce que la couche photosensible (S) contient un polymère comprenant des groupements ester d'o-nitro-carbinol de la formule (I), qui dérive d'un homo- ou d'un copolymérisât de l'acide acrylique, de l'acide méthacrylique, de l'acide maléique, de l'acide fumarique et(ou) de l'acide crotonique.

6. Procédé suivant l'une des revendications 1 à 5, caractérisé en ce que la couche photosensible (S) contient un composé, en particulier un polymère, dont la molécule comprend, à côté des groupements ester d'o-nitro-carbinol de la formule (I), également les groupes réactifs à action réticulante.

7. Procédé suivant la revendication 6, caractérisé en ce que le composé à groupements ester d'o-nitro-carbinol de la formule (I) contient en outre des groupes amine, imine, amide, époxy, hydroxy, isocyanate et(ou) isocyanate bloqués copolymérisés.

8. Procédé suivant l'une des revendications 1 à 5, caractérisé en ce que la couche photosensible (S) contient, à côté du composé à groupements ester d'o-nitro-carbinol de la formule (I), un ou plusieurs composés à action réticulante avec au moins deux groupes réactifs du type cité.

9. Procédé suivant la revendication 8, caractérisé en ce que la couche photosensible (S) contient un composé à action réticulante choisi parmi les époxydes, les isocyanates, les isocyanates bloqués, les α,ω-diisocyanato-polycarbodiimides, les alcools et(ou) les amines.

10. Procédé suivant l'une des revendications 1 à 9, caractérisé en ce que l'épaisseur de la couche photosensible (S) est comprise entre 5 et 500 μm.

11. Procédé suivant l'une des revendications 1 à 10, caractérisé en ce que la couche photosensible (S) contient des additifs et(ou) adjuvants additionnels.

12. Procédé suivant la revendication 11, caractérisé en ce que la couche photosensible (S) contient des plastifiants, des agents d'étalement, des catalyseurs pour le durcissement thermique, des sensibilisateurs, des colorants, des pigments et(ou) des substances photochromes.

13. Procédé suivant la revendication 11, caractérisé en ce que la couche photosensible (S) contient des matières de charge en fines particules au moins dans une région superficielle d'une épaisseur de 1 à 50 μm.

14. Procédé suivant la revendication 13, caractérisé en ce que les matières de charge en fines particules possèdent une granulométrie moyenne entre 0,1 et 6 μm et une dureté supérieure à 4,0 sur l'échelle des duretés de Mohs.

15. Procédé suivant l'une des revendications 1 à 14, caractérisé en ce que le durcissement et la

réticulation thermiques de la couche (S) exposée à la lumière actinique sont effectués à des températures comprises entre 50 et 250 °C.

16. Procédé suivant l'une des revendications 1 à 15, caractérisé en ce que la couche photosensible (S) est exposée à la lumière actinique suivant une image à travers un négatif tramé ou ligné, les parties exposées de la couche (S) étant ensuite éliminées à l'aide d'un solvant révélateur aqueux, puis la couche (S) est soumise à une post-exposition à la lumière actinique sur toute sa surface avant d'être durcie et réticulée par voie thermique.

17. Procédé suivant la revendication 16, caractérisé en ce que la couche photosensible (S) est exposée à la lumière simultanément à travers un négatif tramé ou ligné et à travers un négatif à demi-teintes.

18. Procédé suivant l'une des revendications 1 à 15, caractérisé en ce que la couche photosensible (S) est exposée à la lumière actinique suivant une image à travers un positif tramé ou ligné, puis les régions exposées sont sélectivement durcies et réticulées par voie thermique et les régions non durcies, ni réticulées, de la couche (S) sont ensuite éliminées à l'aide d'un solvant révélateur.

19. Procédé suivant la revendication 18, caractérisé en ce que la couche photosensible (S) est soumise, après le durcissement et la réticulation sélectifs des régions exposées suivant une image, à une post-exposition à la lumière actinique de toute la surface avant d'être traitée au solvant révélateur.

20. Procédé suivant l'une des revendications 1 à 15, caractérisé en ce que la couche photosensible (S) est d'abord exposée suivant une image à la lumière actinique à travers un positif tramé ou ligné, puis les régions exposées de la couche (S) sont sélectivement durcies et réticulées par voie thermique, la couche photosensible (S) étant alors exposée sur une deuxième fois suivant une image à la lumière actinique à travers un négatif à demi-teintes ou tramé, les régions exposées pendant cette deuxième exposition à la lumière de la couche (S) étant éliminées à l'aide d'un solvant révélateur et la couche (S) durcie et réticulée par voie thermique après une post-exposition à la lumière actinique de toute sa surface.

21. Procédé suivant l'une des revendications 1 à 20, caractérisé en ce que l'exposition de la couche photosensible (S) est réalisée à l'aide d'un rayon laser actinique modulé dirigé.